# EUROPÄISCHE PATENTSCHRIFT

(11) **EP 0 980 115 B1**
(45) Veröffentlichungstag und Bekanntmachung des Hinweises auf die Patenterteilung: **16.04.2003**
(21) Anmeldenummer: 99115801.5
(22) Anmeldetag: 11.08.1999
(51) Int. Cl.: H01R 12/18, H01R 12/36, H01R 43/02, H01R 12/02, H05K 3/34, H05K 3/00, H01R 13/05

(54) **Elektrische Leiterplatte mit angelöteten Steckkontaktelementen**
Electric circuit board with soldered pins
Panneau à circuit électrique avec éléments de contact à fiche soudés

(30) Priorität: 12.08.1998 DE 19836456
(43) Veröffentlichungstag der Anmeldung: 16.02.2000
(73) Patentinhaber: Leopold Kostal GmbH & Co. KG, 58507 Lüdenscheid (DE)
(72) Erfinder: Hütz, Uwe, 58566 Kierspe (DE)

(56) Entgegenhaltungen:
- EP-A- 0 557 081
- EP-A- 0 762 559
- FR-A- 2 700 288
- US-A- 4 899 920
- US-A- 5 590 455
- US-A- 5 713 126

## Beschreibung

Die Erfindung betrifft eine elektrische Leiterplatte mit mindestens einem mit seiner Längsachse parallel zur Leiterplattenoberfläche orientierten und mit dieser durch einen Reflow-Lötprozeß verbundenen, vorzugsweise rund ausgeführten Steckkontaktelement.

Der Reflow-Lötprozeß dient zur Herstellung einer Lötverbindung oberflächenmontierbarer, sog. SMD-Bauteile mit Anschlußbereichen einer Leiterplatte. Dazu wird die Leiterplatte an den später die Anschlußbereiche bildenden Lötflächen zunächst mit einer Lötpaste versehen, was z.B. in einem Siebdruckverfahren erfolgen kann. Danach werden die Schaltungskomponenten - in der Regel durch eine automatische Bestückungsmaschine - mit ihren Anschlüssen in die Paste der entsprechenden Lötfläche gedrückt.
Die so bestückte Leiterplatte durchläuft danach in einer Reflow-Lötanlage ein Temperaturprofil, in dem zunächst bestimmte Bestandteile der Lötpaste ausgasen, bevor das enthaltene Flußmittel aktiviert wird, und schließlich in der Aufschmelzzone das in der Lötpaste enthaltene Lotmetall aufgeschmolzen und so die Lötverbindung hergestellt wird.
In dem gesamten Prozeß vom Bestücken der Leiterplatte bis zum Erstarren der Lötverbindung werden die Bauteile allein durch die Adhäsionskraft der Lötpaste in ihrer Position gehalten. Dies ist möglich, da die Bauteile in der Regel relativ klein und leicht sind und jeweils mit mindestens zwei Anschlußkontakten versehen sind.
Oft ist es aber erforderlich, zur späteren Verbindung der so hergestellten elektronischen Schaltung mit anderen Geräten Schnittstellen in Form von Steckverbindern vorzusehen. Kommen bei diesen Steckverbindern insbesondere Steckkontaktelemente zum Einsatz, die mit ihrer Längsachse parallel zur Leiterplattenoberfläche montiert werden müssen, so bietet die eine Kontaktstelle auf der Leiterplatte, die für diese jeweils vorhanden ist, keine Möglichkeit zur ausreichenden Fixierung derselben in der gewünschten Lage. Insbesondere rund ausgeführte Steckkontaktelemente, die zumeist in Gestalt massiver Drehteile vorliegen, sind durch ihre langgestreckte, zylindrische Form sowie eine relativ große Masse gekennzeichnet. Dies bewirkt aber bei den unvermeidlichen Erschütterungen, denen die Leiterplatte im Prozeßverlauf ausgesetzt ist, das Auftreten von Kräften und Drehmomenten, die die von der einen Lötpastenfixierung aufzubringende Haltekraft bei weitem übersteigen.

Aufgabe der vorliegenden Erfindung ist es daher, eine für einen Reflow-Lötprozeß vorgesehene Leiterplatte bereitzustellen, bei der auf der Leiterplatte liegend zu montierende Steckkontaktelemente in einem Arbeitsgang und von den gleichen Vorrichtungen bestückt werden, wie die übrigen Schaltungskomponenten, bei denen es sich insbesondere um SMD-Bauteile handelt, und die Mittel aufweist, um diese Steckkontaktelemente in der vorgesehenen Position bis zur Erstarrung der Lötverbindung zu fixieren.

Die Erfindung löst diese Aufgabe ohne Zuhilfenahme zusätzlicher mechanischer Bauteile, Klebemedien oder ähnlichem, indem sie in der Leiterplatte Ausnehmungen vorsieht, deren Längen und Breiten so bemessen sind, daß sich im Zusammenwirken mit den Längen und Querschnitten der Steckkontaktelemente eine für die Lötung optimale Auflage derselben auf der Leiterplatte ergibt. In einer besonders vorteilhaften Ausführungsform sind die Steckkontaktelemente dabei rund ausgeführt und mit abschnittsweise unterschiedlichen Durchmessern versehen.

Weitere Ausgestaltungen und zweckmäßige Weiterbildungen des erfindungsgemäßen Gegenstandes sind in den zusätzlichen Unteransprüchen angegeben und gehen auch aus der nachfolgenden Beschreibung des in der Zeichnung dargestellten Ausführungsbeispiels hervor. Dabei zeigen:
- **Fig. 1:**: einen Ausschnitt aus einer erfindungsgemäßen, elektrischen Leiterplatte in der Aufsicht auf ihre Oberseite

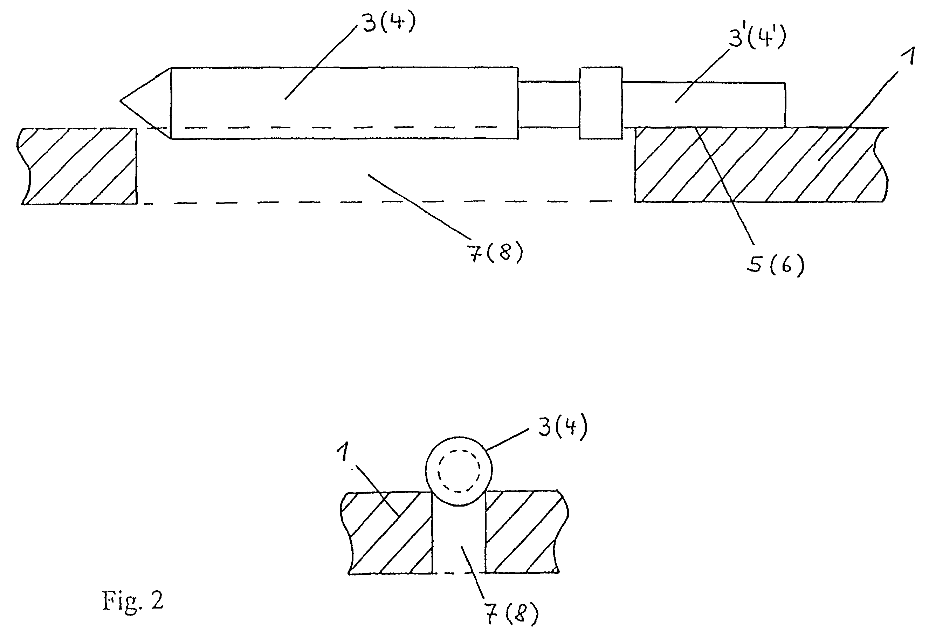

- **Fig 2:**: ein rund ausgeführtes, stiftförmiges Steckkontaktelement auf einer erfindungsgemäßen, elektrischen Leiterplatte im Längs- und Querschnitt

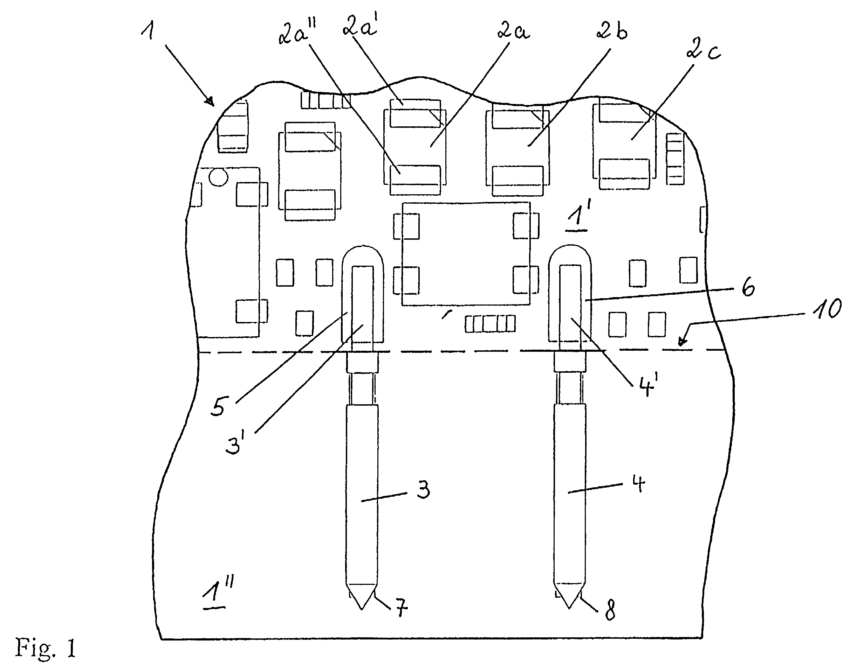

Wie in Fig. 1 zu sehen sind auf der Oberseite einer erfindungsgemäßen, elektrischen Leiterplatte 1 SMD-Komponenten 2a, 2b, 2c, ... montiert, die auf Lötflächen repräsentierenden Anschlußbereichen 2a', 2a'', positioniert sind. Außerdem sind in dem dargestellten Ausschnitt zwei rund ausgeführte, stiftförmige Steckkontaktelemente 3 und 4 zu sehen, die auf der Leiterplatte 1 so positioniert sind, daß ihre mit der Leiterplatte zu kontaktierenden Endabschnitte 3'und 4' auf Lötflächen 5 und 6 aufliegen. Die freien Abschnitte dieser rundstiftförmigen Steckkontaktelemente, die zur späteren Kontaktierung mit den entsprechenden buchsenförmigen Steckkontaktelementen vorgesehen sind, liegen dabei in Schlitzen 7 und 8, die sich parallel zu ihrer Längsachse in der Leiterplatte 1 erstrecken. In dieser gegenüber der Leiterplattenoberfläche vertieften Lage sind die rundstiftförmigem Steckkontaktelemente bei weitgehend waagerechter Haltung der Leiterplatte während des nachfolgenden Handlings durch die Schwerkraft in ihrer Lage fixiert.
Die Länge und Breite der Schlitze in der Leiterplatte sowie die abschnittsweise unterschiedlichen Durchmesser der rundstiftförmigen Steckkontaktelemente sind aufeinander so abgestimmt, daß nicht nur eine ausreichende Fixierung der rundstiftförmigen Steckkontaktelemente bis zum Erstarren der Lötverbindung sowie eine korrekte Position derselben im fertigen Produkt gewährleistet ist, sondern auch eine Auflage der zu kontaktierenden Endabschnitte 3'und 4' auf den Lötflächen 5 und 6, die ein optimales Lötergebnis erwarten läßt.
Nach Fertigstellung der Lötung wird der Abschnitt 1" der Leiterplatte 1 entlang einer Linie 10 von dem Abschnitt 1' abgetrennt, auf dem die elektronischen Bauelemente und Steckkontaktelemente angelötet sind. Die rundstiftförmigen Steckkontaktelemente 3 und 4 werden durch diese Maßnahme freigestellt. Entlang der Linie 10 der vorgesehenen Trennung kann schon bei der Herstellung der unbestückten Leiterplatte eine Schwächung z.B. in Form einer Kerbfräsung eingebracht werden.

Die erfindungsgemäße Leiterplatte eignet sich insbesondere auch zur Realisierung mehrerer, voneinander unabhängiger, gleicher oder unterschiedlicher Schaltkreise, die nach Fertigstellung der Lötung voneinander mechanisch getrennt werden.
Als Steckkontaktelemente können dabei selbstverständlich neben den im dargestellten Ausführungsbeispiel gezeigten stiftförmig und rund ausgeführten ebenso auch buchsenförmige und/oder solche mit anderen als runden Querschnittsformen zum Einsatz kommen.

Mit besonderem Vorteil kann die erfindungsgemäße Leiterplatte bei einem Herstellungsverfahren eingesetzt werden, bei dem die Bestückung der Leiterplatte ausschließlich aus SMD-Komponenten und den Steckkontaktelementen besteht. Bei einem solchen Herstellungsverfahren werden die Steckkontaktelemente dann von den gleichen automatischen Bestückungsmaschinen wie die SMD-Komponenten und in einem Arbeitsgang mit diesen bestückt.

## Patentansprüche

1. Elektrische Leiterplatte (1) mit mindestens einem mit seiner Längsachse parallel zur Leiterplattenoberfläche orientierten und mit einem darauf befindlichen, metallischen Anschlußbereich (5) durch eine Lötstelle verbundenen Steckkontaktelement (3), dem eine Ausnehmung (7) in der Leiterplatte (1) zugeordnet ist, in die es zu seiner lagerichtigen Positionierung und bei weitgehend waagerechter Haltung der Leiterplatte durch die Schwerkraft bewirkten Fixierung vom Zeitpunkt der Bestückung bis zur Erstarrung der Lötstelle zumindest auf einem Teil seiner Länge partiell eintaucht.

2. Elektrische Leiterplatte (1) nach Anspruch 1 mit einer Mehrzahl von Ausnehmungen (7,8) zur Positionierung und Fixierung jeweils eines Steckkontaktelements (3,4).

3. Elektrische Leiterplatte (1) nach Anspruch 1 oder 2, bei der die Steckkontaktelemente (3,4) auf ihrer Länge Abschnitte mit unterschiedlichen Querschnitten aufweisen, und die Abmessungen der Ausnehmungen (7,8) mit diesen unterschiedlichen Querschnitten der ihnen zugeordneten Steckkontaktelemente (3,4) so abgestimmt ist, daß im Bereich der diesen zugeordneten, als Lötfläche anzusehenden, metallischen Anschlußbereiche (5,6) die entsprechenden Abschnitte (3',4') der Steckkontaktelemente (3,4) auf einer Lötpaste aufliegen.

4. Elektrische Leiterplatte (1) nach einem der Ansprüche 1 bis 3, bei der die Steckkontaktelemente (3,4) im Querschnitt rund und die Ausnehmungen (7,8) in Form von parallel zu deren Längsachsen verlaufenden Schlitzen ausgeführt sind.

5. Elektrische Leiterplatte (1) nach einem der Ansprüche 1 bis 4, die mehrere voneinander unabhängige elektrische Schaltkreise trägt, und die nach dem Lötprozeß durch mechanische Trennung in mehrere, einzelne, jeweils einen Schaltkreis aufweisende Subleiterplatten (1') aufgeteilt ist.

6. Elektrische Leiterplatte (1) nach einem der Ansprüche 1 bis 5, bei der sich die Ausnehmungen (7,8) in Bereichen (1") der Leiterplatte befinden, die nach dem Lötprozeß keine Funktion mehr zu erfüllen haben und somit durch mechanische Trennung von zumindest einer einen elektrischen Schaltkreis tragenden Subleiterplatte (1') entfernt sind.

7. Elektrische Leiterplatte (1) nach einem der Ansprüche 1 bis 6, die zumindest einseitig mit SMD-Komponenten (2a,2b,2c,...) bestückt ist.

8. Verfahren zur Herstellung einer elektrischen Leiterplatte (1) mit zumindest einem mit seiner Längsachse parallel zur Leiterplattenoberfläche orientierten und mit einem darauf befindlichen, metallischen Anschlußbereich (5) durch eine Lötstelle verbundenen Steckkontaktelement (3), umfassend das Bestücken der Leiterplatte (1) mit dem zumindest einen Steckkontaktelement (3), das zu seiner lagerichtigen Positionierung und bei weitgehend waagerechter Haltung der Leiterplatte (1) durch die Schwerkraft bewirkten Fixierung vom Zeitpunkt der Bestückung bis zur Erstarrung der Lötstelle zumindest auf einem Teil seiner Länge partiell in eine Ausnehmung (7) auf der Leiterplatte (1) eintaucht sowie das Reflow-Löten der bestückten Leiterplatte (1)

9. Verfahren nach Anspruch 8, bei dem die Leiterplatte (1) nach Erstarrung der Lötstellen in einzelne Subleiterplatten (1') geteilt wird und/oder Abfallstücke (1") abgetrennt werden.

## Claims

1. Electric printed circuit board (1) with at least one plug contact (3) orientated with its longitudinal axis parallel to the top surface of the printed circuit board and connected to a metal terminal area (5) located on the same by means of a solder joint, with a cut-out (7) in the printed circuit board (1) assigned to the said plug contact (3) in which at least part of its length immerges to ensure its correctly positioned placement when the printed circuit board is held in a mainly horizontal attitude from the time of placement until the solder joint has cured as a result of the fixation effected by gravity.

2. Electric printed circuit board (1) according to Claim 1 with a plurality of cut-outs (7,8) each for positioning and fixing one plug contact (3,4).

3. Electric printed circuit board (1) according to Claim 1 or Claim 2, in which the lengths of the plug contacts (3,4) feature sections of differing profiles and the dimensions of the cut-outs (7,8) are coordinated to these differing profiles of the plug contact assigned to them respectively in such a way that the relevant sections (3',4') of the plug contacts (3,4) come to lie on a solder paste in the area of the terminal pads (5,6) assigned to these which are to be regarded as solder pads.

4. Electric printed circuit board (1) according to any of Claims 1 to 3, in which the plug contacts (3,4) are round in profile and the cut-outs (7,8) are designed in the form of slots running parallel to the longitudinal axes of the same.

5. Electric printed circuit board (1) according to any of Claims 1 to 4 which bears several electrical circuits that are independent of each other and which is divided by mechanical separation into several individual subordinate printed circuit boards (1'), each featuring one circuit, subsequent to the soldering process.

6. Electric printed circuit board (1) according to any of Claims 1 to 5 in which the cut-outs (7,8) are located in areas (1") of the printed circuit board which need not fulfil any further functions after the soldering process and are consequently removed by the mechanical separation of at least one subordinate printed circuit board (1') bearing one electrical circuit.

7. Electric printed circuit board (1) according to any of Claims 1 to 6 which is equipped at least on one side with SMD components (2a, 2b, 2c...).

8. Process for manufacturing an electric printed circuit board (1) having at least one plug contact (3) whose longitudinal axis is orientated parallel to the top surface of the printed circuit board and which is connected to a metallic terminal pad (5) located on the same by way of a solder joint, which process encompasses, firstly, the assembly of the printed circuit board (1) with the at least one plug contact (3) which immerges with at least part of its length into a cut-out (7) on the printed circuit board (1) for the purpose of ensuring its correctly positioned assembly and with the mainly horizontal attitude of the printed circuit board (1) causing it to be fixed in position by means of gravity from the moment it is assembled until the solder joint solidifies, and secondly, the reflow soldering of the assembled printed circuit board (1).

9. Process according to Claim 8, in which the printed circuit board (1) is divided into individual subordinate printed circuit boards (1') and/or waste segments (1") are broken off after the solder joints have cured.

## Revendications

1. Plaquette à circuits imprimés (1) avec au moins un élément de contact enfichable (3) qui, présentant un axe longitudinal orienté parallèlement à la surface de la plaquette à circuits imprimés, est relié par joint brasé à une zone de raccordement métallique (5) et est coordonné à un évidement (7), pratiqué dans la plaquette de circuit imprimés (1), dans lequel il plonge, tout au moins partiellement, sur une partie de sa longueur, pour y être positionné correctement, fixé sous l'action de la force de pesanteur, du moment de l'équipement jusqu'à la solidification de la brasure, la plaquette de circuits imprimés étant maintenue en position horizontale, dans la mesure du possible.

2. Plaquette à circuits imprimés (1) selon la revendication 1, avec plusieurs évidements (7, 8), prévus chacun pour le positionnement et la fixation d'un élément de contact enfichable (3, 4).

3. Plaquette à circuits imprimés (1) selon la revendication 1 ou 2, dans laquelle les éléments de contact enfichables (3, 4) qui présentent, sur leur longueur, des secteurs de diamètres différents, et les dimensions des évidements (7, 8) sont adaptées à ces différentes coupes transversales des éléments de contact enfichables (3, 4) correspondants, de sorte que, dans le secteur des zones de raccordement (5, 6), qui leur sont coordonnées et sont à considérer comme étant des surfaces de brasage, les tronçons (3', 4') des éléments de contact enfichables (3, 4) portent sur une pâte à brasure.

4. Plaquette à circuits imprimés selon l'une des revendications 1 à 3, dans laquelle les éléments de contact enfichables (3, 4) présentent une section transversale ronde et les évidements (7, 8) sont exécutés en forme de fentes qui s'étendent parallèlement aux axes longitudinaux desdits contacts enfichables.

5. Plaquette à circuits imprimés (1) selon l'une des revendications 1 à 4, laquelle porte plusieurs circuits de commutation électriques, indépendants les uns des autres, et est divisée, après l'opération de brasage, par séparation mécanique, en plusieurs sous-plaquettes individuelles dont chacune présente un circuit de commutation.

6. Plaquette à circuits imprimés (1) selon l'une des revendications 1 à 5, dans laquelle les évidements (7, 8) sont situés dans des zones (1") de la plaquette de circuits qui, après le processus de brasage, n'ont plus aucune fonction à remplir et sont donc enlevées par séparation mécanique d'au moins l'une des sous-plaquettes (1') qui portent un circuit de commutation électrique.

7. Plaquette de circuits imprimés (1) selon l'une des revendications 1 à 6, qui est équipée, au moins sur un côté, de composants SMD (2a, 2b, 2c,...).

8. Procédé pour la fabrication d'une plaquette à circuits imprimés (1) avec au moins un élément de contact enfichable (3) qui présente un axe longitudinal orienté parallèlement à la surface de la plaquette à circuits imprimés et est relié, par joint brasé, à une zone de raccordement métallique (5), lequel procédé comprend l'équipement de la plaquette à circuits imprimés (1) avec au moins un élément de contact enfichable (3) qui plonge, tout au moins partiellement, sur une partie de sa longueur, dans un évidement (7), pratiqué dans la plaquette de circuits imprimés (1), pour y être positionné correctement, fixé sous l'action de la pesanteur, du moment de l'équipement jusqu'à la solidification de la brasure, la plaquette de circuits imprimés étant maintenue en position horizontale, dans la mesure du possible,
ainsi que le brasage par re-fusion de la plaquette à circuits imprimés (1) équipée.

9. Procédé selon la revendication 8, au cours duquel la plaquette de circuits imprimés (1) est divisée en sous-plaquettes (1') individuelles et / ou en pièces de rebus (1"), après solidification de la brasure.
